# EUROPÄISCHE PATENTSCHRIFT

(11) **EP 4 010 912 B1**
(45) Veröffentlichungstag und Bekanntmachung des Hinweises auf die Patenterteilung: **24.04.2024**
(21) Anmeldenummer: 20771205.0
(22) Anmeldetag: 20.08.2020
(51) Int. Cl.: H01F 38/36, G01R 15/18

(54) **MESSWANDLERANORDNUNG MIT EINEM SPANNUNGSWANDLER UND EINEM STROMWANDLER**
MEASUREMENT TRANSFORMER ASSEMBLY, COMPRISING A VOLTAGE TRANSFORMER AND A CURRENT TRANSFORMER
ENSEMBLE TRANSFORMATEUR DE MESURE COMPRENANT UN TRANSFORMATEUR DE TENSION ET UN TRANSFORMATEUR DE COURANT

(30) Priorität: 20.09.2019 DE 102019214368
(43) Veröffentlichungstag der Anmeldung: 15.06.2022
(73) Patentinhaber: Siemens Energy Global GmbH & Co. KG, 81739 München (DE)
(72) Erfinder: GABER, Michael, 96117 Weichendorf (DE); PRUCKER, Udo, 90571 Schwaig (DE)
(86) Internationale Anmeldenummer: PCT/EP2020/073287
(87) Internationale Veröffentlichungsnummer: WO 2021/052702

(56) Entgegenhaltungen:
- EP-A1- 3 474 024
- EP-A2- 0 236 974
- WO-A1-2018/113954

## Beschreibung

Die Erfindung betrifft eine Messwandleranordnung mit einem Spannungswandler und einem Stromwandler.

Mit anderen Worten betrifft die Erfindung einen so genannten Kombiwandler, der einen Spannungswandler und einen Stromwandler in einem Gerät kombiniert. Derartige Kombiwandler werden insbesondere in Hochspannungsschaltanlagen eingesetzt, um hohe elektrische Ströme und Spannungen proportional und phasengenau zu Mess-, Schutz- oder Steuerungszwecken auf niedrigere Werte zu transformieren. Spannungswandler weisen in der Regel einen Magnetkern auf, um den herum eine Spannungswandlerprimärwicklung und wenigstens eine Spannungswandlersekundärwicklung verlaufen. Stromwandler weisen in der Regel einen Stromwandlerprimärleiter auf, um den herum wenigstens eine Stromwandlersekundärwicklung verläuft. Der Stromwandlerprimärleiter kann eine oder mehrere Windungen aufweisen. Insbesondere kann die Windungszahl eines Stromwandlerprimärleiters variabel ausgebildet sein, beispielsweise indem einzelne Windungsabschnitte miteinander elektrisch in Reihe verschaltbar sind.

Aus den Dokumenten EP 3 474 024 A1 und EP 0 236 974 A2 sind jeweils Messwandleranordnungen mit den Merkmalen des jeweiligen Oberbegriffs der Ansprüche 1 und 6 bekannt.

Der Erfindung liegt die Aufgabe zugrunde, einen verbesserten Kombiwandler anzugeben, der einen Stromwandlerprimärleiter mit einer variablen Windungszahl aufweist und bei dem das Spannungswandlerprimärteil mit dem Ende des Stromwandlerprimärleiters elektrisch verbindbar ist.

Die Aufgabe wird erfindungsgemäß durch eine Messwandleranordnung mit den Merkmalen des Anspruchs 1 und alternativ mit den Merkmalen des Anspruchs 6 gelöst.

Vorteilhafte Ausgestaltungen der Erfindung sind Gegenstand der Unteransprüche.

Eine erfindungsgemäße Messwandleranordnung umfasst einen Spannungswandler mit einem Spannungswandlergehäuse und einer Spannungswandlerprimärwicklung und einen Stromwandler mit einem elektrisch leitfähigen Stromwandlergehäuse, das mit dem Spannungswandlergehäuse zu einem Gehäuse der Messwandleranordnung verbunden ist. Der Stromwandler umfasst einen von der Spannungswandlerprimärwicklung elektrisch isolierten ersten Primärleiteranschluss, einen mit einem ersten Ende der Spannungswandlerprimärwicklung elektrisch verbindbaren zweiten Primärleiteranschluss und mehrere, beispielsweise vier, durch das Stromwandlergehäuse hindurchgeführte Primärleiterabschnitte, wobei eine auswählbare Anzahl mehrerer Primärleiterabschnitte elektrisch in Reihe zu einem die Primärleiteranschlüsse elektrisch verbindenden Stromwandlerprimärleiter verschaltbar ist. Eine derartige Verschaltung mehrerer Primärleiterabschnitte umfasst eine elektrische Verbindung zweier Primärleiterabschnitte über das Stromwandlergehäuse.

Eine erfindungsgemäße Messwandleranordnung ist ein Kombiwandler, dessen Stromwandler mehrere miteinander seriell verschaltbare Primärleiterabschnitte aufweist, wobei durch die Anzahl miteinander verschalteter Primärleiterabschnitte die Windungszahl des Stromwandlerprimärleiters einstellbar ist. Dabei wird das Stromwandlergehäuse zur Verschaltung zweier Primärleiterabschnitte verwendet. Dadurch wird vorteilhaft eine Rückleitung eingespart, über die diese beiden Primärleiterabschnitte andernfalls miteinander verbunden werden müssten. Ferner ermöglicht die Erfindung vorteilhaft, ein Ende der Spannungswandlerprimärwicklung des Spannungswandlers eines Kombiwandlers mit dem Ende des Stromwandlerprimärleiters des Stromwandlers des Kombiwandlers elektrisch zu verbinden. Eine derartige Verschaltung der Spannungswandlerprimärwicklung und des Stromwandlerprimärleiters wird bei speziellen Anwendungen benötigt, beispielsweise für eine Schutzauslegung des Kombiwandlers.

Bei der ersten von zwei Alternativlösungen im Sinne der Erfindung ist das Spannungswandlergehäuse elektrisch leitfähig ausgebildet und gegenüber dem Stromwandlergehäuse elektrisch isoliert. Ferner ist das erste Ende der Spannungswandlerprimärwicklung elektrisch mit dem Spannungswandlergehäuse verbunden, und der zweite Primärleiteranschluss ist elektrisch mit dem Spannungswandlergehäuse verbindbar, beispielsweise durch ein außerhalb des Stromwandlergehäuses anordenbares elektrisch leitfähiges Verbindungselement. Bei dieser Ausgestaltung der Erfindung kann die elektrische Verbindung des ersten Endes der Spannungswandlerprimärwicklung mit dem Ende des Stromwandlerprimärleiters vorteilhaft durch Verbinden des zweiten Primärleiteranschlusses des Stromwandlers mit dem Stromwandlergehäuse hergestellt werden, insbesondere durch ein außerhalb des Stromwandlergehäuses angeordnetes elektrisch leitfähiges Verbindungselement. Dies vereinfacht das Verbinden der Spannungswandlerprimärwicklung mit dem Stromwandlerprimärleiter erheblich beispielsweise gegenüber einem Verbinden im Innern des Stromwandlergehäuses und/oder des Stromwandlergehäuses.

Bei einer Weitergestaltung der vorgenannten Ausgestaltung der Erfindung ist das erste Ende der Spannungswandlerprimärwicklung über einen elektrisch leitfähigen Pressrahmen, in dem ein Magnetkern des Spannungswandlers fixiert ist, elektrisch mit dem Spannungswandlergehäuse verbunden. Dabei ist der Pressrahmen beispielsweise an dem Spannungswandlergehäuse oder elektrisch isoliert an dem Stromwandlergehäuse befestigt. Diese Weitergestaltung nutzt also vorteilhaft einen in der Regel ohnehin vorhandenen Pressrahmen, um das erste Ende der Spannungswandlerprimärwicklung elektrisch mit dem Stromwandlergehäuse zu verbinden.

Bei der zweiten der beiden Alternativlösung im Sinne der Erfindung ist das erste Ende der Spannungswandlerprimärwicklung elektrisch isoliert von dem Spannungswandlergehäuse aus dem Spannungswandlergehäuse herausgeführt und mit dem zweiten Primärleiteranschluss elektrisch verbindbar. Bei dieser Ausgestaltung der Erfindung ist also das Ende der Spannungswandlerprimärwicklung nicht mit dem Spannungswandlergehäuse elektrisch verbunden, sondern wird elektrisch isoliert aus dem Spannungswandlergehäuse herausgeführt, um erforderlichenfalls mit dem zweiten Primärleiteranschluss elektrisch verbunden werden zu können.

Bei einer weiteren Ausgestaltung der Erfindung weist die Messwandleranordnung eine Anzahl von Rückleitern auf, die um Zwei kleiner als die Anzahl der Primärleiterabschnitte ist, wobei jeder Rückleiter von dem Stromwandlergehäuse und dem Spannungswandlergehäuse elektrisch isoliert ist und über jeden Rückleiter zwei Primärleiterabschnitte in Reihe schaltbar sind. Beispielsweise ist jeder Rückleiter außerhalb des Stromwandlergehäuses angeordnet. Durch eine Anzahl von Rückleitern, die um Zwei kleiner als die Anzahl der Primärleiterabschnitte ist, können vorteilhaft erforderlichenfalls alle Primärleiterabschnitte in Reihe verschaltet werden, da das Stromwandlergehäuse die Funktion eines weiteren Rückleiters übernimmt. Die Anordnung der Rückleiter außerhalb des Stromwandlergehäuses vereinfacht vorteilhaft das Verschalten der Primärleiterabschnitte, beispielsweise gegenüber einer Anordnung der Rückleiter im Innern des Stromwandlergehäuses.

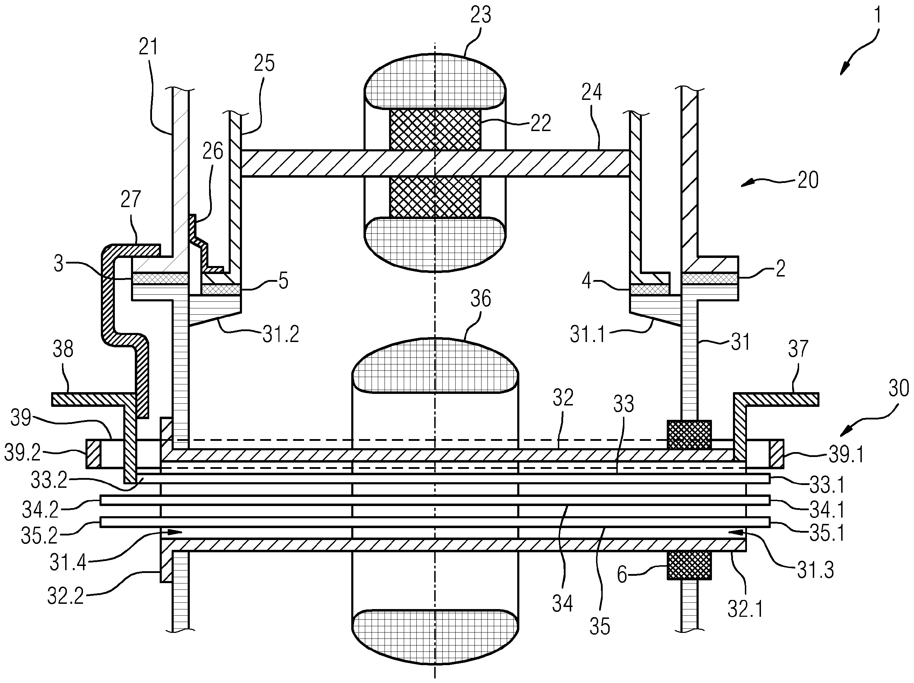

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert werden. Dabei zeigt die einzige Figur eine Schnittdarstellung eines Ausführungsbeispiels einer erfindungsgemäßen Messwandleranordnung 1 mit einem Spannungswandler 20 und einem Stromwandler 30.

Der Spannungswandler 20 ist über dem Stromwandler 30 angeordnet und weist ein elektrisch leitfähiges Spannungswandlergehäuse 21, eine Spannungswandlerprimärwicklung 22, eine Spannungswandlersekundärwicklung 23, einen Magnetkern 24, einen elektrisch leitfähigen Pressrahmen 25 und ein elektrisch leitfähiges erstes Verbindungselement 26 auf.

Die Spannungswandlerprimärwicklung 22 verläuft um einen Abschnitt des Magnetkerns 24 herum. Ein hochspannungsseitiges erstes Ende der Spannungswandlerprimärwicklung 22 ist elektrisch mit dem Pressrahmen 25 verbunden.

Die Spannungswandlersekundärwicklung 23 verläuft von der Spannungswandlerprimärwicklung 22 elektrisch isoliert um die Spannungswandlerprimärwicklung 22 herum.

Der Pressrahmen 25 fixiert den Magnetkern 24 und ist durch das Verbindungselement 26 elektrisch mit dem Spannungswandlergehäuse 21 verbunden.

Der Stromwandler 30 umfasst ein elektrisch leitfähiges Stromwandlergehäuse 31, vier Primärleiterabschnitte 32 bis 35, eine Stromwandlersekundärwicklung 36, zwei außerhalb des Stromwandlergehäuses 31 angeordnete Primärleiteranschlüsse 37, 38 und zwei Rückleiter 39, von denen in der Figur nur einer sichtbar ist.

Das Stromwandlergehäuse 31 ist mit dem Spannungswandlergehäuse 21 durch eine Flanschverbindung 2 verbunden, von dem Spannungswandlergehäuse 21 aber durch eine zwischen dem Spannungswandlergehäuse 21 und dem Stromwandlergehäuse 31 angeordnete erste Isolierung 3 elektrisch isoliert. Das Stromwandlergehäuse 31 weist zwei innenseitige Halterungen 31.1, 31.2 für den Pressrahmen 25 auf, an denen der Pressrahmen 25 befestigt ist, wobei eine erste Halterung 31.1 durch eine zweite Isolierung 4 und die zweite Halterung 31.2 durch eine dritte Isolierung 5 von dem Pressrahmen 25 elektrisch isoliert sind. In dem in der Figur dargestellten Ausführungsbeispiel sind die Isolierungen 3 bis 5 jeweils separat ausgeführt. In anderen Ausführungsbeispielen können diese Isolierungen 3 bis 5 aber auch als ein einstückig ausgeführter Isolierkörper ausgeführt sein.

Ein erster Primärleiterabschnitt 32 ist als ein elektrisch leitfähiges Rohr ausgebildet, das durch das Stromwandlergehäuse 31 verläuft und zwei durch jeweils eine Gehäuseöffnung 31.3, 31.4 aus dem Stromwandlergehäuse 31 herausgeführte Enden 32.1, 32.2 aufweist. Ein erstes Ende 32.1 ist elektrisch mit einem ersten Primärleiteranschluss 37 verbunden. Im Bereich einer ersten Gehäuseöffnung 31.3, durch die das erste Ende 32.1 aus dem Stromwandlergehäuse 31 herausragt, ist der erste Primärleiterabschnitt 32 durch eine vierte Isolierung 6 von dem Stromwandlergehäuse 31 elektrisch isoliert. Das zweite Ende 32.2 ist flanschartig ausgebildet, liegt in dem Bereich der zweiten Gehäuseöffnung 31.4 an dem Stromwandlergehäuse 31 an und ist dadurch in diesem Bereich elektrisch leitend mit dem Stromwandlergehäuse 31 verbunden. Die weiteren Primärleiterabschnitte 33, 34, 35 sind voneinander und von dem ersten Primärleiterabschnitt 32 elektrisch isoliert durch den ersten Primärleiterabschnitt 32 und jeweils beidseitig aus dem Stromwandlergehäuse 31 herausgeführt.

Die Stromwandlersekundärwicklung 36 verläuft von dem ersten Primärleiterabschnitt 32 beabstandet um einen Mittelabschnitt des ersten Primärleiterabschnitts 32 herum.

Jeder Rückleiter 39 ist außerhalb des Stromwandlergehäuses 31 angeordnet, weist ein in der Nähe des ersten Primärleiteranschlusses 37 angeordnetes erstes Rückleiterende 39.1 und ein in der Nähe des zweiten Primärleiteranschlusses 38 angeordnetes zweites Rückleiterende 39.2 auf, und verläuft zwischen seinen beiden Rückleiterenden 39.1, 39.2 etwa halbumfänglich um das Stromwandlergehäuse 31 herum, wobei die beiden Rückleiter 39 auf sich gegenüberliegenden Seiten des Stromwandlergehäuses 31 angeordnet sind. Der in der Figur gezeigte Rückleiter 39 verläuft hinter der Zeichenebene der Figur etwa halbumfänglich um das Stromwandlergehäuse 31 herum, der andere Rückleiter 39 verläuft vor der Zeichenebene der Figur etwa halbumfänglich um das Stromwandlergehäuse 31 herum. Die Rückleiter 39 sind voneinander und von dem Stromwandlergehäuse 31 und den Primärleiteranschlüssen 37, 38 elektrisch isoliert.

Der zweite Primärleiteranschluss 38 ist durch ein elektrisch leitfähiges zweites Verbindungselement 27 elektrisch mit dem Spannungswandlergehäuse 21 verbindbar. Beispielsweise ist das zweite Verbindungselement 27 durch Schraubverbindungen mit dem zweiten Primärleiteranschluss 38 und dem Spannungswandlergehäuse 21 verbindbar.

Eine auswählbare Anzahl mehrerer Primärleiterabschnitte 32 bis 35 ist elektrisch in Reihe zu einem die Primärleiteranschlüsse 37, 38 elektrisch verbindenden Stromwandlerprimärleiter verschaltbar, wobei eine derartige Verschaltung eine elektrische Verbindung zweier Primärleiterabschnitte 32 bis 35 über das Stromwandlergehäuse 31 umfasst. Weitere bei einer derartigen Reihenschaltung zu verschaltende Primärleiterabschnitte 32 bis 35 werden dann über eine oder beide Rückleiter 39 miteinander verschaltet.

Der erste Primärleiteranschluss 37 ist mit dem ersten Ende 32.1 des ersten Primärleiterabschnitts 32 elektrisch verbunden. Der zweite Primärleiteranschluss 38 ist mit einem zweiten Ende 33.2 eines zweiten Primärleiterabschnitts 33 elektrisch verbunden. Um in diesem Fall den ersten Primärleiterabschnitt 32 mit dem zweiten Primärleiterabschnitt 33 elektrisch in Reihe zu verschalten, wird das dem zweiten Ende 33.2 gegenüberliegende erste Ende 33.1 des zweiten Primärleiterabschnitt 33 elektrisch mit dem Stromwandlergehäuse 31 verbunden. Der dadurch entstehende Stromwandlerprimärleiter verläuft von dem ersten Primärleiteranschluss 37 über den ersten Primärleiterabschnitt 32 zu dem zweiten Ende 32.2 des ersten Primärleiterabschnitts 32, von dort über das Stromwandlergehäuse 31 zu dem ersten Ende 33.1 des zweiten Primärleiterabschnitts 33, und von dort über den zweiten Primärleiterabschnitt 33 zu dem zweiten Primärleiteranschluss 38. Der Stromwandlerprimärleiter wird dabei also nur von den beiden Primärleiterabschnitten 32, 33 und dem Stromwandlergehäuse 31 gebildet, während die anderen beiden Primärleiterabschnitte 34, 35 und die beiden Rückleiter 39 ungenutzt bleiben. Der Stromwandlerprimärleiter weist in diesem Fall zwei Windungen auf.

Alternativ kann bei dem in der Figur gezeigten Beispiel beispielsweise ein erstes Ende 34.1 eines dritten Primärleiterabschnitts 34 elektrisch mit dem Stromwandlergehäuse 31 verbunden werden und das zweite Ende 34.2 des dritten Primärleiterabschnitts 34 über einen Rückleiter 39 elektrisch mit dem ersten Ende 33.1 des zweiten Primärleiterabschnitts 33 elektrisch verbunden werden. Der Stromwandlerprimärleiter wird dann von den drei Primärleiterabschnitten 32, 33, 34, dem Stromwandlergehäuse 31 und einem Rückleiter 39 gebildet, während der Primärleiterabschnitt 35 und der andere Rückleiter 39 ungenutzt bleiben. Der Stromwandlerprimärleiter weist in diesem Fall drei Windungen auf.

Schließlich kann bei dem in der Figur gezeigten Beispiel ein erstes Ende 35.1 des vierten Primärleiterabschnitts 35 elektrisch mit dem Stromwandlergehäuse 31 verbunden werden, das zweite Ende 35.2 des vierten Primärleiterabschnitts 35 über einen Rückleiter 39 elektrisch mit dem ersten Ende 34.1 des dritten Primärleiterabschnitts 34 elektrisch verbunden werden, und das zweite Ende 34.2 des dritten Primärleiterabschnitts 34 über den anderen Rückleiter 39 elektrisch mit dem ersten Ende 33.1 des zweiten Primärleiterabschnitts 33 elektrisch verbunden werden. Der Stromwandlerprimärleiter wird dann von allen vier Primärleiterabschnitten 32 bis 35, dem Stromwandlergehäuse 31 und den beiden Rückleitern 39 gebildet und weist vier Windungen auf.

Bei einem zu der in der Figur gezeigten Messwandleranordnung 1 alternativen Ausführungsbeispiel ist der Pressrahmen 25 nicht elektrisch isoliert an dem Stromwandlergehäuse 31, sondern an dem Spannungswandlergehäuse 21 befestigt und mit dem Spannungswandlergehäuse 21 direkt elektrisch verbunden.

Bei einem weiteren alternativen Ausführungsbeispiel ist das erste Ende der Spannungswandlerprimärwicklung 22 elektrisch isoliert durch eine Durchführung aus dem Spannungswandlergehäuse 21 herausgeführt (und nicht elektrisch mit dem Pressrahmen 25 verbunden) und mit dem zweiten Primärleiteranschluss 38 elektrisch verbindbar, wobei die Durchführung gas- und druckdicht beziehungsweise öldicht ausgeführt ist, falls das Spannungswandlergehäuse 21 und das Stromwandlergehäuse 31 mit einem Gas beziehungsweise mit einem Öl befüllt werden. In diesem Fall ist eine elektrische Isolierung des Spannungswandlergehäuses 21 von dem Stromwandlergehäuse 31 nicht erforderlich, unabhängig davon, ob der Pressrahmen 25 an dem Stromwandlergehäuse 31 oder an dem Spannungswandlergehäuse 21 befestigt ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Messwandleranordnung (1), umfassend
- einen Spannungswandler (20) mit einem Spannungswandlergehäuse (21) und einer Spannungswandlerprimärwicklung (22) und
- einen Stromwandler (30) mit einem elektrisch leitfähigen Stromwandlergehäuse (31), das mit dem Spannungswandlergehäuse (21) zu einem Gehäuse der Messwandleranordnung (1) verbunden ist, einem von der Spannungswandlerprimärwicklung (22) elektrisch isolierten ersten Primärleiteranschluss (37), einem zweiten Primärleiteranschluss (38) und mehreren durch das Stromwandlergehäuse (31) hindurchgeführten Primärleiterabschnitten (32 bis 35), wobei der erste und der zweite Primärleiteranschluss (37, 38) außerhalb des Stromwandlergehäuses (31)angeordnet sind, und wobei
- eine auswählbare Anzahl mehrerer Primärleiterabschnitte (32 bis 35) elektrisch in Reihe zu einem die Primärleiteranschlüsse (37, 38) elektrisch verbindenden Stromwandlerprimärleiter verschaltbar ist, wobei eine derartige Verschaltung eine elektrische Verbindung zweier Primärleiterabschnitte (32 bis 35) über das Stromwandlergehäuse (31) umfasst,
**dadurch gekennzeichnet, dass**
der zweite Primärleiteranschluss (38) mit einem ersten Ende der Spannungswandlerprimärwicklung (22) elektrisch verbindbar ist,
wobei das Spannungswandlergehäuse (21) elektrisch leitfähig ausgebildet und gegenüber dem Stromwandlergehäuse (31) elektrisch isoliert ist, das erste Ende der Spannungswandlerprimärwicklung (22) elektrisch mit dem Spannungswandlergehäuse (21) verbunden ist und der zweite Primärleiteranschluss (38) elektrisch mit dem Spannungswandlergehäuse (21) verbindbar ist.

2. Messwandleranordnung (1) nach Anspruch 1,
wobei das erste Ende der Spannungswandlerprimärwicklung (22) durch ein außerhalb des Stromwandlergehäuses (31) anordenbares elektrisch leitfähiges Verbindungselement (27) elektrisch mit dem Spannungswandlergehäuse (21) verbindbar ist.

3. Messwandleranordnung (1) nach Anspruch 1 oder 2,
wobei das erste Ende der Spannungswandlerprimärwicklung (22) über einen elektrisch leitfähigen Pressrahmen (25), in dem ein Magnetkern (24) des Spannungswandlers (20) fixiert ist, elektrisch mit dem Spannungswandlergehäuse (21) verbunden ist.

4. Messwandleranordnung (1) nach Anspruch 3,
wobei der Pressrahmen (25) an dem Spannungswandlergehäuse (21) befestigt ist.

5. Messwandleranordnung (1) nach Anspruch 3,
wobei der Pressrahmen (25) elektrisch isoliert an dem Stromwandlergehäuse (31) befestigt ist.

6. Messwandleranordnung (1) umfassend
- einen Spannungswandler (20) mit einem Spannungswandlergehäuse (21) und einer Spannungswandlerprimärwicklung (22) und
- einen Stromwandler (30) mit einem elektrisch leitfähigen Stromwandlergehäuse (31), das mit dem Spannungswandlergehäuse (21) zu einem Gehäuse der Messwandleranordnung (1) verbunden ist, einem von der Spannungswandlerprimärwicklung (22) elektrisch isolierten ersten Primärleiteranschluss (37), einem zweiten Primärleiteranschluss (38) und mehreren durch das Stromwandlergehäuse (31) hindurchgeführten Primärleiterabschnitten (32 bis 35), wobei der erste und der zweite Primärleiteranschluss (37, 38) außerhalb des Stromwandlergehäuses (31)angeordnet sind, und wobei
- eine auswählbare Anzahl mehrerer Primärleiterabschnitte (32 bis 35) elektrisch in Reihe zu einem die Primärleiteranschlüsse (37, 38) elektrisch verbindenden Stromwandlerprimärleiter verschaltbar ist, wobei eine derartige Verschaltung eine elektrische Verbindung zweier Primärleiterabschnitte (32 bis 35) über das Stromwandlergehäuse (31) umfasst,
**dadurch gekennzeichnet, dass**
der zweite Primärleiteranschluss (38) mit einem ersten Ende der Spannungswandlerprimärwicklung (22) elektrisch verbindbar ist,
wobei das erste Ende der Spannungswandlerprimärwicklung (22) elektrisch isoliert von dem Spannungswandlergehäuse (21) aus dem Spannungswandlergehäuse (21) herausgeführt und mit dem zweiten Primärleiteranschluss (38) elektrisch verbindbar ist.

7. Messwandleranordnung (1) nach einem der vorhergehenden Ansprüche mit einer Anzahl von Rückleitern (39), die um Zwei kleiner als die Anzahl der Primärleiterabschnitte (32 bis 35) ist,
wobei jeder Rückleiter (39) von dem Stromwandlergehäuse (31) und dem Spannungswandlergehäuse (21) elektrisch isoliert ist und über jeden Rückleiter (39) zwei Primärleiterabschnitte (32 bis 35) in Reihe schaltbar sind.

8. Messwandleranordnung (1) nach Anspruch 7,
wobei jeder Rückleiter (39) außerhalb des Stromwandlergehäuses (31) angeordnet ist.

9. Messwandleranordnung (1) nach einem der vorhergehenden Ansprüche mit vier Primärleiterabschnitten (32 bis 35).

## Claims

1. Measuring transformer arrangement (1), comprising
- a voltage transformer (20) having a voltage transformer housing (21) and a voltage transformer primary winding (22), and
- a current transformer (30) having an electrically conductive current transformer housing (31) which is connected to the voltage transformer housing (21) to form a housing of the measuring transformer arrangement (1), a first primary conductor connection (37) electrically insulated from the voltage transformer primary winding (22), a second primary conductor connection (38), and a plurality of primary conductor sections (32 to 35) routed through the current transformer housing (31), wherein the first and the second primary conductor connection (37, 38) are arranged outside the current transformer housing (31), and wherein
- a selectable number of the plurality of primary conductor sections (32 to 35) are able to be electrically interconnected in series to form a current transformer primary conductor electrically connecting the primary conductor connections (37, 38), wherein such an interconnection comprises an electrical connection of two primary conductor sections (32 to 35) via the current transformer housing (31),
**characterized in that**
the second primary conductor connection (38) is able to be electrically connected to a first end of the voltage transformer primary winding (22),
wherein the voltage transformer housing (21) is electrically conductive and is electrically insulated with respect to the current transformer housing (31), the first end of the voltage transformer primary winding (22) is electrically connected to the voltage transformer housing (21), and the second primary conductor connection (38) is able to be electrically connected to the voltage transformer housing (21).

2. Measuring transformer arrangement (1) according to Claim 1,
wherein the first end of the voltage transformer primary winding (22) is able to be electrically connected to the voltage transformer housing (21) by an electrically conductive connection element (27) which is able to be arranged outside the current transformer housing (31).

3. Measuring transformer arrangement (1) according to Claim 1 or 2,
wherein the first end of the voltage transformer primary winding (22) is electrically connected to the voltage transformer housing (21) via an electrically conductive clamping frame (25) in which a magnetic core (24) of the voltage transformer (20) is fixed.

4. Measuring transformer arrangement (1) according to Claim 3,
wherein the clamping frame (25) is fastened to the voltage transformer housing (21).

5. Measuring transformer arrangement (1) according to Claim 3,
wherein the clamping frame (25) is fastened to the current transformer housing (31) in an electrically insulated manner.

6. Measuring transformer arrangement (1) comprising
- a voltage transformer (20) having a voltage transformer housing (21) and a voltage transformer primary winding (22), and
- a current transformer (30) having an electrically conductive current transformer housing (31) which is connected to the voltage transformer housing (21) to form a housing of the measuring transformer arrangement (1), a first primary conductor connection (37) electrically insulated from the voltage transformer primary winding (22), a second primary conductor connection (38), and a plurality of primary conductor sections (32 to 35) routed through the current transformer housing (31), wherein the first and the second primary conductor connection (37, 38) are arranged outside the current transformer housing (31), and wherein
- a selectable number of the plurality of primary conductor sections (32 to 35) are able to be electrically interconnected in series to form a current transformer primary conductor electrically connecting the primary conductor connections (37, 38), wherein such an interconnection comprises an electrical connection of two primary conductor sections (32 to 35) via the current transformer housing (31),
**characterized in that**
the second primary conductor connection (38) is able to be electrically connected to a first end of the voltage transformer primary winding (22),
wherein the first end of the voltage transformer primary winding (22) is routed out of the voltage transformer housing (21) in a manner electrically insulated from the voltage transformer housing (21) and is able to be electrically connected to the second primary conductor connection (38).

7. Measuring transformer arrangement (1) according to one of the preceding claims, having a number of return conductors (39) which is two fewer than the number of the primary conductor sections (32 to 35),
wherein each return conductor (39) is electrically insulated from the current transformer housing (31) and from the voltage transformer housing (21), and each return conductor (39) is able to be used to connect two primary conductor sections (32 to 35) in series.

8. Measuring transformer arrangement (1) according to Claim 7,
wherein each return conductor (39) is arranged outside the current transformer housing (31).

9. Measuring transformer arrangement (1) according to one of the preceding claims, having four primary conductor sections (32 to 35).

## Revendications

1. Dispositif (1) transducteur de mesure, comprenant
- un transformateur (20) de tension ayant un boîtier (21) de transformateur de tension et un enroulement (22) primaire de transformateur de tension et
- un transformateur (30) de courant ayant un boîtier (31) transformateur de courant, qui est conducteur de l'électricité et qui est relié au boîtier (21) de transformateur de tension en un boîtier du dispositif (1) de transducteur de mesure, une première borne (37) de conducteur primaire isolée électriquement de l'enroulement (22) primaire de transformateur de tension, une deuxième borne (38) de conducteur primaire et plusieurs tronçons (32 à 35) de conducteur primaire traversant le boîtier (31) de transformateur de courant, dans lequel la première et la deuxième bornes (37, 38) de conducteur primaire sont disposées à l'extérieur du boîtier (31) de transformateur de courant, et dans lequel
- un nombre pouvant être sélectionné de plusieurs tronçons (32 à 35) de conducteur primaire peut être monté électriquement en série avec un conducteur primaire de transformateur de courant reliant électriquement les bornes (37, 38) de conducteur primaire, dans lequel un montage de ce genre comprend une liaison électrique de deux tronçons (32 à 35) de conducteur primaire par le boîtier (31) de transformateur de courant,
**caractérisé en ce que**
la deuxième borne (38) de conducteur primaire peut être reliée électriquement à une première extrémité de l'enroulement (22) primaire de transformateur de tension,
dans lequel le boîtier (21) transformateur de tension est conducteur de l'électricité et est isolé électriquement du boîtier (31) de transformateur de courant, la première extrémité de l'enroulement (22) primaire de transformateur de tension est reliée électriquement au boîtier (21) de transformateur de tension et la deuxième borne (38) de conducteur primaire peut être reliée électriquement au boîtier (21) de transformateur de tension.

2. Dispositif (1) transducteur de mesure suivant la revendication 1,
dans lequel la première extrémité de l'enroulement (22) primaire de transformateur de tension peut être reliée électriquement au boîtier (21) de transformateur de tension par un élément (27) de liaison conducteur de l'électricité pouvant être monté à l'extérieur du boîtier (31) de transformateur de courant.

3. Dispositif (1) transducteur de mesure suivant la revendication 1 ou 2,
dans lequel la première extrémité de l'enroulement (22) primaire de transformateur de tension est reliée électriquement au boîtier (21) de transformateur de tension par un câble (25) de pression conducteur de l'électricité, dans lequel un noyau (24) magnétique du transformateur (20) de tension est fixé.

4. Dispositif (1) transducteur de mesure suivant la revendication 3,
dans lequel le cadre (25) de pression est fixé au boîtier (21) de transformateur de tension.

5. Dispositif (1) transducteur de mesure suivant la revendication 3,
dans lequel le cadre (25) de pression est fixé d'une manière isolée électriquement au boîtier (31) de transformateur de courant.

6. Dispositif (1) transducteur de mesure comprenant
- un transformateur (20) de tension ayant un boîtier (21) de transformateur de tension et un enroulement (22) primaire de transformateur de tension et
- un transformateur (30) de courant ayant un boîtier (31) transformateur de courant, qui est conducteur de l'électricité et qui est relié au boîtier (21) de transformateur de tension en un boîtier du dispositif (1) de transducteur de mesure, une première borne (37) de conducteur primaire isolée électriquement de l'enroulement (22) primaire de transformateur de tension, une deuxième borne (38) de conducteur primaire et plusieurs tronçons (32 à 35) de conducteur primaire traversant le boîtier (31) de transformateur de courant, dans lequel la première et la deuxième bornes (37, 38) de conducteur primaire sont disposées à l'extérieur du boîtier (31) de transformateur de courant, et dans lequel
- un nombre pouvant être sélectionné de plusieurs tronçons (32 à 35) de conducteur primaire peut être monté électriquement en série avec un conducteur primaire de transformateur de courant reliant électriquement les bornes (37, 38) de conducteur primaire, dans lequel un montage de ce genre comprend une liaison électrique de deux tronçons (32 à 35) de conducteur primaire par le boîtier (31) de transformateur de courant,
**caractérisé en ce que**
la deuxième borne (38) de conducteur primaire peut être reliée électriquement à une première extrémité de l'enroulement (22) primaire de transformateur de tension,
dans lequel la première extrémité de l'enroulement (22) primaire de transformateur de tension sort du boîtier (21) de transformateur de tension à l'état isolé électriquement du boîtier (21) de transformateur de tension et peut être reliée électriquement à la deuxième borne (38) de conducteur primaire.

7. Dispositif (1) transducteur de mesure suivant l'une des revendications précédentes, comprenant un nombre de conducteurs (39) de retour, qui est plus petit que le nombre des tronçons (32 à 35) de conducteur primaire,
dans lequel chaque conducteur (39) de retour est isolé électriquement du boîtier (31) de transformateur de courant et du boîtier (21) de transformateur de tension et, par chaque conducteur (39) de retour, deux tronçons (32 à 35) de conducteur primaire peuvent être montés en série.

8. Dispositif (1) transducteur de mesure suivant la revendication 7,
dans lequel chaque conducteur (39) de retour est disposé à l'extérieur du boîtier (31) de transformateur de courant.

9. Dispositif (1) transducteur de mesure suivant l'une des revendications précédentes, comprenant quatre tronçons (32 à 35) de conducteur primaire.
